# EUROPEAN PATENT APPLICATION

(11) **EP 4 239 813 A1**
(43) Date of publication of application: **06.09.2023**
(21) Application number: 22305247.3
(22) Date of filing: 03.03.2022
(51) Int. Cl.: H01S 5/10, H01S 5/14, H01S 3/08, H01S 5/0687, H01S 3/10, H01S 5/026, H01S 5/02, H01S 5/06

(54) **TUNABLE LASER AND METHODS**

(71) Applicant: Nokia Solutions and Networks Oy, 02610 Espoo (FI)
(72) Inventor: BITAULD, David, 91300 MASSY (FR)
(74) Representative: Swindell & Pearson Limited

(57) **Abstract**

A tunable laser comprising:
filtering means configured to select a lasing mode of the tunable laser;
means for determining a phase difference introduced by the filtering means; and
means for tuning the lasing wavelength and/or filtering means transmission based, at least in part, on the determined phase difference.

## Description

### TECHNOLOGICAL FIELD

Embodiments of the present disclosure relate to a tunable laser and methods. Some relate to an integrated tunable laser and methods.

### BACKGROUND

Tunable lasers, such as integrated tunable lasers, are used in many applications ranging from coherent optical telecommunications, fiber sensing, optical coherent tomography, spectroscopy and so on.

It would be desirable to enhance tunable lasers.

### BRIEF SUMMARY

According to various, but not necessarily all, embodiments there is provided a tunable laser comprising:
filtering means configured to select a lasing mode of the tunable laser;
means for determining a phase difference introduced by the filtering means; and
means for tuning the lasing wavelength and/or filtering means transmission based, at least in part, on the determined phase difference.

In some examples, the tunable laser comprises at least one optical amplifier and light guiding means, wherein the at least one optical amplifier and light guiding means are configured as an optical cavity to produce laser light at a plurality of different modes having different wavelengths and wherein the light guiding means comprise the filtering means.

In some examples, the filtering means are configured to filter light to select a mode from the plurality of modes.

In some examples, the filtering means comprise at least one ring resonator.

In some examples, the means for determining a phase difference are configured to measure a phase difference between a ring resonator input and through ports, a ring resonator input and drop ports, or a ring resonator drop and through ports.

In some examples, the means for determining a phase difference comprises at least one interferometer.

In some examples, the filtering means comprises at least one ring resonator and the means for determining a phase difference comprises a plurality of interferometers per ring resonator.

In some examples, the light guiding means are configured to control the phase of light entering the means for determining a phase difference.

In some examples, the tunable laser comprises an integrated tunable laser.

In some examples, the means for tuning the lasing wavelength and/or filtering means transmission comprises heating means and/or means for injecting carriers into one or more waveguides.

According to various, but not necessarily all, embodiments there is provided a tunable laser as described herein and means for measuring the lasing wavelength.

According to various, but not necessarily all, embodiments there is provided a system comprising:
at least one tunable laser as described herein;
means for receiving signal output from the means for determining a phase difference; and
means for controlling the means for tuning the lasing wavelength and/or filtering means transmission.

According to various, but not necessarily all, embodiments there is provided a method comprising:
providing a tunable laser comprising:
filtering means configured to select a lasing mode of the tunable laser;
means for determining a phase difference introduced by the filtering means; and
means for tuning the lasing wavelength and/or filtering means transmission based, at least in part, on the determined phase difference.

According to various, but not necessarily all, embodiments there is provided a method comprising using at least one tunable laser as described herein

According to various, but not necessarily all, embodiments there is provided a method comprising:
determining a phase difference introduced by filtering means of a tunable laser; and
tuning a lasing wavelength and/or filtering means transmission of the tunable laser based, at least in part, on the determined phase difference.

According to various, but not necessarily all, embodiments there is provided an apparatus comprising means for performing at least part of one or more methods disclosed herein.

According to various, but not necessarily all, embodiments there is provided examples as claimed in the appended claims.

The description of a function should additionally be considered to also disclose any means suitable for performing that function.

### BRIEF DESCRIPTION

Some examples will now be described with reference to the accompanying drawings in which:
FIG. 1 shows an example of the subject-matter described herein;
FIG. 2 shows another example of the subject-matter described herein;
FIG. 3 shows another example of the subject-matter described herein;
FIG. 4 shows another example of the subject-matter described herein;
FIG. 5 shows another example of the subject-matter described herein;
FIG. 6 shows another example of the subject-matter described herein;
FIG. 7 shows another example of the subject-matter described herein; and
FIG. 8 shows another example of the subject-matter described herein.

### DETAILED DESCRIPTION

Examples of the disclosure relate to a tunable laser 10 and associated methods. In examples, the associated methods comprise a method of providing a tunable laser 10 and methods of using at least one tunable laser 10.

In some examples, the tunable laser 10 comprises:
filtering means 12 configured to select a lasing mode 14 of the tunable laser 10;
means for determining 16 a phase difference 54 introduced by the filtering means 12; and
means for tuning 18 the lasing wavelength 42 and/or filtering means transmission 44 based, at least in part, on the determined phase difference 54.

As used herein, an apparatus and/or component for performing one or more actions should also be considered to disclose an apparatus and/or component configured to perform the one or more actions.

Similarly, as used herein, an apparatus and/or component configured to perform one or more actions should also be considered to disclose an apparatus and/or component for performing the one or more actions.

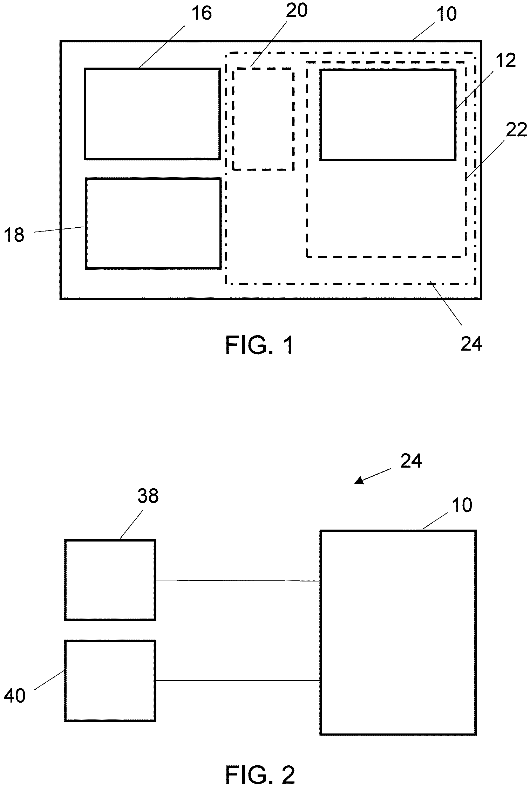

FIG. 1 schematically illustrates an example of a tunable laser 10.

Various features referred to in relation to FIG. 1 can be found in the other figures.

In the example of FIG. 1, the tunable laser 10 comprises:
filtering means 12 configured to select a lasing mode 14 of the tunable laser 10;
means for determining 16 a phase difference 54 introduced by the filtering means 12; and
means for tuning 18 the lasing wavelength 42 and/or filtering means transmission 44 based, at least in part on the determined phase difference 54.

The tunable laser 10 can comprise any suitable tunable laser 10, configured in any suitable way.

As used herein, a tunable laser 10 can be considered a laser whose wavelength of operation, or wavelength of lasing mode 14, can be controllably altered and/or changed.

In some examples, a tunable laser 10 can be considered a laser comprising filtering means 12 configured to tune and/or select a lasing mode 14 of the laser 10.

In some, but not necessarily all, examples, the tunable laser 10 comprises an integrated tunable laser.

As used herein, an integrated tunable laser can be considered a tunable laser that is integrated onto one or more chips, for example silicon chips.

The filtering means 12 can comprise any suitable filtering means 12 configured to select a lasing mode 14 of the tunable laser 10.

For example, the filtering means 12 can comprise any suitable filtering means 12 configured to select a lasing mode 14 of a plurality of possible lasing modes 46 of the tunable laser 10.

In examples, the filtering means 12 can be considered at least one filter, at least one filtering arrangement, at least one filtering structure, at least one filtering mechanism, at least one filtering apparatus and so on.

In some examples, the filtering means 12 can be considered at least one resonator configured to select and tune the wavelength of the tunable laser 10.

In examples, the filtering means 12 comprise one or more photonic integrated circuits and/or one or more light filtering structures and/or arrangements and/or elements and/or components and/or apparatus.

In some examples, the filtering means 12 comprise at least one ring resonator 26. A ring resonator 26 can, in some examples, be considered an optical ring resonator.

In some examples, the filtering means 12 comprises one or Mach Zehnder interferometers and/or one or more Bragg mirrors.

In examples, the filtering means 12 are configured to control transmission of light as a function of wavelength.

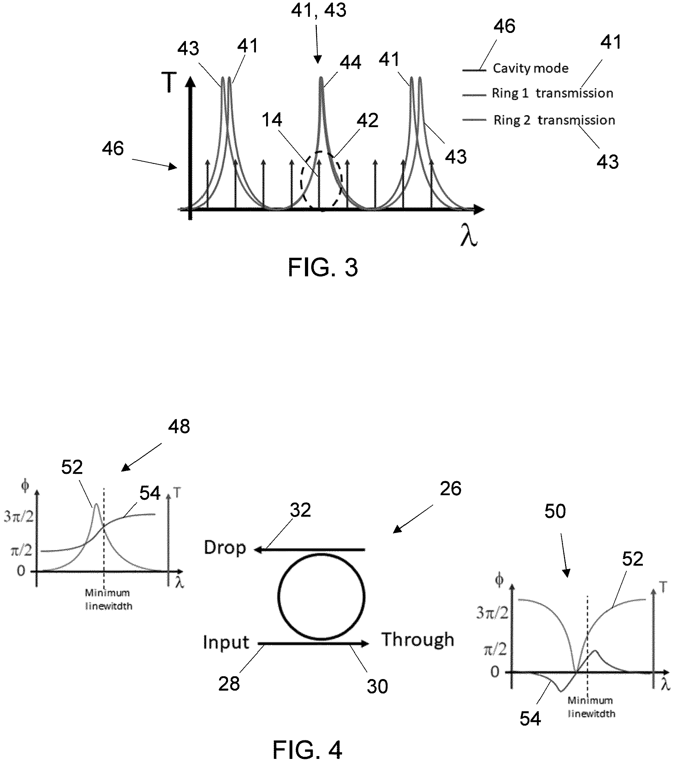

By way of example, reference is made to FIG. 3. Various features referred to in relation to FIG. 3 can be found in the other figures.

FIG. 3 shows an example of power transmission T as a function of wavelength A for filtering means 12 of a tunable laser 10.

In the example of which FIG. 3 shows the power transmission/wavelength characteristic, the filtering means 12 comprise two ring resonators 26. Accordingly, in the example of FIG. 3, the transmission properties of the two ring resonators 26 as a function of wavelength are illustrated.

In the example of FIG. 3, the transmission curves of the first ring are indicated by the numeral 41 and the transmission curves of the second ring are indicated by the numeral 43.

The curves illustrated in FIG. 3 show the filtering means transmission 44 for the two ring resonators 26. It can be seen, in the example of FIG. 3, that the central curves of the ring resonators transmission 44 overlap around the centre of the plot.

Also illustrated in the example of FIG. 3 are the possible lasing modes 46 (denoted by the upright arrows) for the tunable laser 10 in the example of FIG. 3.

The plurality of arrows extending from the lower axis in FIG. 3 illustrate the plurality of lasing modes 46 that are possible for the tunable laser 10.

In examples, the lasing modes 46 can be considered cavity modes. In examples, the cavity longitudinal modes are defined by the optical length of the optical cavity 24 of the tunable laser 10.

In some examples, such as those of which FIG. 3 shows the power/wavelength characteristic, the filtering means 12 are configured to function as a Vernier filter. These filters are well known to the skilled person.

In some examples, the tunable laser 10 comprises at least one optical amplifier 20 and light guiding means 22, wherein the at least one optical amplifier 20 and light guiding means 22 are configured as an optical cavity 24 to produce laser light at a plurality of different modes 46 having different wavelengths and wherein the light guiding means 22 comprise the filtering means 12.

The at least one optical amplifier 20 can comprise any suitable optical amplifier or amplifiers 20 configured to produce light. For example, the at least one optical amplifier 20 can comprise any suitable optical amplifier(s) 20 configured to produce light to provide a tunable laser 10.

In examples, the at least one optical amplifier 20 can be considered at least one gain material, at least one gain chip and so on.

In examples, any suitable electrically pumped semiconductor, optically pumped solid, optically pumped liquid and/or optically pumped gas material can be used as the optical amplifier 20.

In examples, the at least one optical amplifier 20 is configured to produce light in any suitable wavelength range. For example, the at least one optical amplifier 20 can be configured to produce light in the range of ultraviolet to mid-infrared.

In some, but not necessarily all, examples, the at least one optical amplifier 20 is configured to produce light in the range 1260 to 1625nm.

In examples, the at least one optical amplifier 20 comprises at least one semiconductor optical amplifier.

Any suitable semiconductor optical amplifier can be used. For example, any suitable semiconductor optical amplifier comprising any suitable material(s) can be used.

For example, a III-V semiconductor, quantum well, quantum dot semiconductor, quantum cascade semiconductor and/or inter-band cascade semiconductor can be used.

In examples, the tunable laser 10 can comprise any suitable number of the same or different optical amplifiers 20.

In examples, the light guiding means 22 are configured to control and/or direct and/or affect and/or manipulate light in the tunable laser 10.

In some examples, the light guiding means 22 can be considered at least one light guide, at least one light guiding arrangement, at least one light guiding structure, at least one optical arrangement, at least one optical structure, at least one light controlling arrangement, at least one light controlling structure, and/or at least one light guiding apparatus and so on.

In examples, the light guiding means 22 comprise one or more photonic integrated circuits and/or one or more discrete light guiding/controlling structures and/or arrangements and/or elements and/or components and/or apparatus.

In examples, the light guiding means 22 can comprise any suitable component(s) to control and/or direct and/or affect and/or manipulate light in the tunable laser 10.

For example, the light guiding means 22 can comprise one or more reflective components/structures/arrangements/apparatus, one or more refractive components/structures/arrangements/apparatus, and/or one or more diffractive components/structures/arrangements/apparatus, and so on.

For example, the light guiding means 22 can comprise one or more lenses, one or more wave guides, one or more mirrors 58, one or more coatings, one or more reflectors, one or more diffractors, and/or one or more refractors and so on.

In some examples, the light guiding means 22 can comprise any suitable terminations placed at any suitable points, for example at unused ports of ring resonators 26, to expel light from the light guiding means 22 to, for example, avoid back reflections.

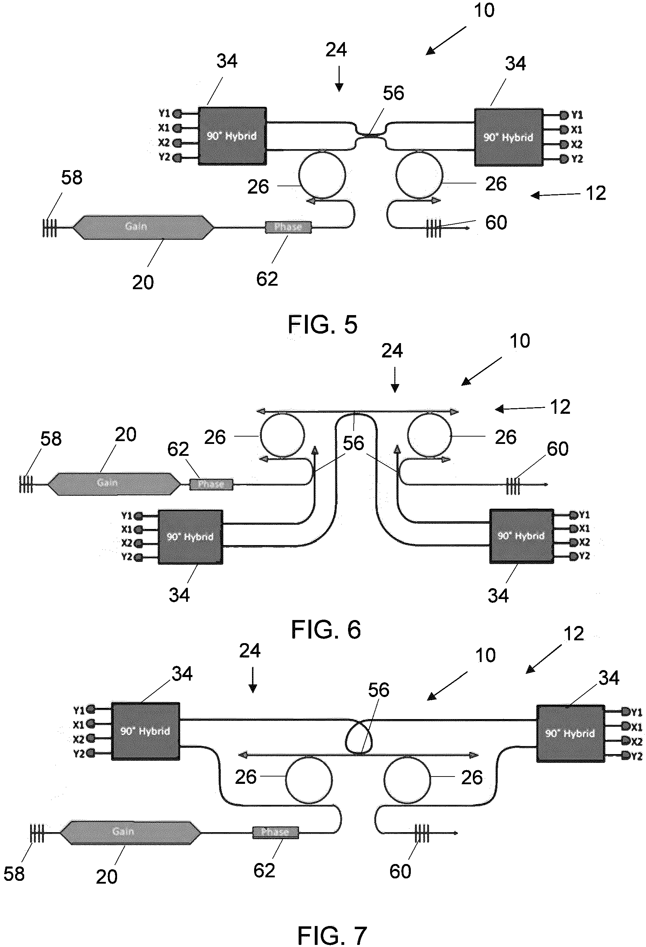

In some examples, the light guiding means 22 comprise a mirror, such as a high reflection mirror 58, and an output coupler 60. See, for example, FIGS. 5 to 7.

In such examples, the lasing modes 46/cavity longitudinal modes can be defined by the optical length between the high reflection mirror 58 and the output coupler 60.

The output coupler 60 can comprise any suitable form for outputting light from the tunable laser 10.

For example, the output coupler 60 can comprise any suitable component or components configured to output light from the tunable laser 10.

In some examples the output coupler 60 can comprise: a Sagnac loop, a DBR grating, and/or a facet of a chip and so on.

In examples comprising a loop cavity laser, the output coupler 60 can comprise a directional coupler, an adiabatic coupler, and/or an MMI and so on.

In some examples, the filtering means 12 are configured to filter light to select a mode 46 from the plurality of modes 46.

Referring again to the example of FIG. 3, in this example, it can be seen that for the configuration resulting in this power wavelength characteristic, the filtering means 12, in the form of two ring resonators 26, are configured to select the highlighted mode to be the lasing wavelength 42.

That is, in the example of FIG. 3, the filtering means transmission 44 has been controlled to select a lasing mode 14 of the possible lasing modes 46 which, in the example of FIG. 3, is indicated by a dashed circle. The lasing mode 14 will have an associated lasing wavelength 42.

Accordingly, in the example of FIG. 3, the filtering means transmission 44 is configured and/or controlled to filter light to select the mode 14 from the plurality of modes 46.

However, in examples, the filtering means 12 can be configured in any suitable way to select a mode 46 from the plurality of modes.

In examples, the means for determining 16 a phase difference 54 introduced by the filtering means 12 can comprise any suitable means for determining a phase difference introduced by the filtering means.

As used herein, the term "determining" (and grammatical variants thereof) can include, at least: calculating, computing, processing, deriving, investigating, looking up (for example, looking up in a table, a database or another data structure), ascertaining and the like. Also, "determining" can include receiving (for example, receiving information), accessing (for example, accessing data in a memory) and the like. Also, "determining" can include resolving, selecting, choosing, establishing, and the like

The means for determining 16 can be considered means for determining 16 a phase difference 54 introduced and/or caused by light passing through the filtering means 12.

In some examples, the means for determining 16 a phase difference 54 introduced by the filtering means 12 can be considered means for determining 16 the detuning between the filtering means 12 and the lasing wavelength 42.

In examples where the filtering means comprise at least one ring resonator 26, the means for determining 16 can be considered means for determining 16 the detuning between the ring's resonance and the lasing wavelength 42.

In some examples, the means for determining 16 can be considered means for determining 16 an offset between a peak transmission wavelength of the filtering means 12 and the lasing wavelength 42.

For example, referring again to the example of FIG. 3, the means for determining 16 can be configured to determine the offset between the lasing wavelength 42 and the peak of the rings' transmission 44.

Put another way, the means for determining 16 be configured to determine a phase difference introduced by the offset/detuning between the lasing wavelength 42 and the peak of the filtering means transmission 44.

In examples, the means for determining 16 can be considered at least one determiner, at least one determining arrangement, at least one determining structure, at least one determining component, and/or at least one determining apparatus and so on.

In examples, the means for determining 16 can comprise any suitable component(s) configured to determine a phase difference 54 introduced by the filtering means 12.

In examples, the means for determining 16 can comprise any suitable component(s) configured to determine a phase difference 54 introduced and/or caused by light passing through the filtering means 12.

In some examples, the means for determining 16 a phase difference 54 are configured to measure a phase difference 54 between a ring resonator input and through port 28, 30, a ring resonator input and drop port 28, 32, or a ring resonator drop and through ports 32, 30. See, for example, Figs 5 to 7.

By way of example, reference is made to the example of Fig. 4.

In the example of Fig. 4, a ring resonator 26 is illustrated and the input port 28, through port 30, and drop port 32 of the ring resonator 26 indicated.

Also illustrated in the example of Fig. 4 are plots/graphs 48, 50 of the power transmission 52 and phase difference 54 between the input and drop ports 28, 32 of the ring resonator 26 (left plot 48 of Fig. 4) and between the input and through ports 28, 30 of the ring resonator 26 (right plot 50 of Fig. 4).

In some examples, the means for determining 16 a phase difference comprises at least one interferometer 34. In examples, any suitable interferometer(s) 34 can be used.

For example, the means for determining 16 can comprise a 90-degree hybrid, for example implemented in the form of a 4X4 multimode interferometer (MMI).

In examples, the four outputs (X1, Y1, X2, Y2) of the 90-degree hybrid interferometer 34 can be connected to two pairs of balanced detectors providing measurements X2-X1 and Y2-Y1.

In such examples, the phase difference 54 can be calculated by the formula φ=atan2(X2-X1,Y2-Y1).

See, for example, Figs. 5 to 7.

Any suitable hybrid interferometer 34, such as one or more 180-degree hybrid (2X2 coupler) or one or more 120-degree hybrid can be used.

In some examples, the filtering means 12 comprises at least one ring resonator 26 and the means for determining 16 a phase difference 54 comprises a plurality of interferometers 34 per ring resonator 26.

For example, as the light travels in both directions in the optical cavity 24 of the tunable laser 10, in some examples the tunable laser 10 comprises two interferometers 34 per ring resonator 26, a first interferometer 34 configured to measure the light going forward and a second interferometer 34 configured to measure the light going backward.

In examples, any suitable means for tuning 18 the lasing wavelength 42 and/or filtering means transmission 44 based, at least in part, on the determined phase difference 54 can be used.

For example, any suitable means for changing and/or altering the lasing wavelength 42 and/or changing the filtering means transmission 44 can be used.

For example, with reference to Fig. 3, any suitable means for moving the lasing wavelength 42 left or right and/or any suitable means for moving filtering means transmission 44 left or right can be used.

In examples, the means for tuning 18 the lasing wavelength 42 and/or filtering means transmission 44 can be considered means for changing the phase difference introduced by the filtering means 12.

In examples, the means for tuning 18 the lasing wavelength 42 and/or filtering means transmission 44 can be considered means for changing a wavelength of the lasing mode 46 and/or a peak transmission wavelength of the filtering means 12.

In examples, the means for tuning 18 can be considered at least one tuner, at least one tuning arrangement, at least one tuning structure and/or at least one tuning apparatus and so on.

In examples, the means for tuning 18 is configured to tune and/or change and/or move and/or effect and/or manipulate the lasing wavelength 42 and/or filtering means transmission 44 based, at least in part, on the determined phase difference 54.

In examples, the means for tuning 18 can comprise any suitable component or components configured to tune the lasing wavelength 42 and/or filtering means transmission 44.

In examples, the means for tuning 18 is configured to effect and/or change and/or alter at least a portion of the light guiding means 22 to tune the lasing wavelength 42 and/or filtering means transmission 44.

For example, the means 18 for tuning can be configured to effect and/or change and/or alter at least a portion of one or more waveguides of the light guiding means 22 and/or at least a portion of the filtering means 12.

In examples, the means 18 for tuning comprises means for tuning at least one ring resonator 26.

In some examples, the means 18 for tuning the lasing wavelength 42 and/or filtering means transmission 44 is configured to change and/or effect and/or alter the effective index of at least a portion of the light guiding means 22.

For example, the means 18 for tuning the lasing wavelength 42 and/or filtering means transmission 44 can be configured to change the effective index of at least a portion of a waveguide and/or at least a portion of at least one ring resonator 26.

In some examples, the light guiding means 22 comprise a phase section configured to tune the lasing wavelength 42.

In examples, a phase section 62 can comprise any suitable component(s) and/or can be configured in any suitable way.

For example, the phase section 62 can be configured in any suitable way to controllably change the lasing wavelength 42 of the tunable laser 10.

In the examples, the phase section 62 comprises a waveguide, the effective index of which can be changed by, for example, changing the temperature and/or injecting carriers and so on.

In some examples, the means for tuning 18 the lasing wavelength 42 and/or filtering means transmission 44 comprises heating means and/or means for injecting carriers into one or more waveguides.

In examples, the carriers can be, for example, electrons and/or holes.

In examples, the heating means can comprise any suitable means for controlling the temperature of at least one ring resonator and/or at least a portion of a waveguide.

In examples, the heating means can be considered at least one heater, at least one heating arrangement, at least one heating structure and/or at least one heating mechanism.

In some examples, a first side of a waveguide, for example in a phase section 62 and/or ring resonator 26, can be p-doped and the other side can be n-doped to obtain a PN or PIN junction.

Accordingly, in some examples, the carrier density can be affected and/or modulated and/or controlled by injecting current or applying a voltage to such a junction.

In examples, tuning the lasing wavelength 42 and/or filtering means transmission 44 based, at least in part, on the determined phase difference is advantageous and/or provides technical benefits.

Tuning the lasing wavelength 42 and/or filtering means transmission 44 can be used to affect and/or control one or more characteristics of the light produced by the tunable laser 10.

For example, tuning the lasing wavelength 42 and/or filtering means transmission 44 increases the power output of a tunable laser 10 by, for example, bringing the lasing wavelength 42 and peak transmission of the filtering means 12 closer together.

In some examples, the lasing wavelength 42 and/or filtering means transmission 44 can be controlled to provide a predetermined detuning and/or difference between the lasing wavelength 42 and peak transmission of the filtering means 12 to reduce the linewidth of the tunable laser 12 based on the detuned loading effect.

Accordingly, in examples, the means for tuning 18 the lasing wavelength 42 and/or filtering means transmission 44 based, at least in part, on the determined phase difference 54 are configured to control one or more characteristics of the light produced by the tunable laser 10.

In some examples, the light guiding means 22 are configured to control the phase of light entering the means for determining 16 a phase difference 54.

For example, the length of waveguides used in the light guiding means 22 can be selected and/or configured to ensure that the light propagating in the waveguides does not result in a difference phase, which would be wavelength dependent.

Accordingly, in examples where the optical length of the waveguides of the light guiding means 22 is equal the phase difference in the system can be considered null except for the phase difference 54 added by the filtering means 12, such as one or more ring resonators 26.

However, in some examples, the waveguides used in the light guiding means 22 may not be the same length. In examples, this would introduce a phase offset to be calibrated.

In examples, the calibration could be done in any suitable way, for example by measuring the phases with interferometers 34 while tuning/sweeping/changing the lasing wavelength 42.

In some examples, the tunable laser 10 comprises means for measuring the lasing wavelength 42. Any suitable means for measuring the lasing wavelength 42 can be used.

In examples, means for measuring the lasing wavelength 42 can be considered at least one measurer, at least one measurement arrangement, at least one measurement structure, at least one measurement component, at least one measurement device and/or at least one measurement apparatus and so on.

In examples, the means for measuring the lasing wavelength 42 comprises at least one integrated wavemeter.

In examples, the measurement of the lasing wavelength 42 combined with the measurement of the phase difference 54 introduced by the filtering means 12 can allow a determination of the absolute wavelength of the filtering means 12, for example, the absolute wavelength of the resonance of one or more ring resonators 26.

In examples, the tunable laser 10 can comprise any number of additional components, including no additional components.

In some examples, one or more components can be omitted and/or combined.

Examples of the disclosure are advantageous and/or provide technical benefits.

For example, directly measuring the phase difference introduced by the filtering means, such as one or more ring resonators, allows and/or provides for one or more characteristics, such as power and/or linewidth, of the tunable laser 10 to be readily controlled.

Otherwise, without the inventive examples of the disclosure described herein, doing so is difficult to achieve and/or to maintain.

In examples, there is also provided a system 24 comprising at least one tunable laser 10 as described herein, means for receiving signal output from the means for determining 16 a phase difference 54, and means for controlling the means for tuning 18 the lasing wavelength 42 and/or filtering means transmission 44. See, for example, Fig. 2.

Fig. 2 schematically illustrates an example of a system 24.

The system 24 comprises a tunable laser 10 as described herein, means for receiving signal output from the means for determining 16 a phase difference 54 and means for controlling the means for tuning 18 the lasing wavelength 42 and/or filtering means transmission 44.

In examples, any suitable means for receiving signal output from the means for determining 16 a phase difference 54 can be used.

In examples, the means for receiving signal output can be considered means for measuring signal output.

In examples, the means for receiving signal output from the means for determining 16 a phase difference 54 can be considered signal receiving hardware, signal receiving software, one or more signal receiving mechanisms, signal receiving circuity and/or one or more signal receiving apparatuses and so on.

In examples, any suitable means for controlling the means for tuning 18 the lasing wavelength 42 and/or filtering means transmission 44 can be used.

For example, any suitable electronic control(s) configured to control the means for tuning 18 the lasing wavelength 42 and/or filtering means transmission 44 can be used.

In examples, the means for controlling the means for tuning 18 the lasing wavelength 42 and/or filtering means transmission 44 can be considered control hardware, control software, one or more control mechanisms, control circuitry and/or one or more control apparatuses and so.

In some, but not necessarily all, examples, the signal can be digitized by ADCs and processed with a computer, a microcontroller and/or an FPGA.

In some, but not necessarily all, examples, the controlling signals are produced by DACs.

Fig. 5 schematically illustrates an example of a tunable laser 10.

In the example of Fig. 5, the tunable laser 10 comprises a mirror 58, at least one optical output amplifier 20, filtering means 12 in the form of two ring resonators 26 and an output coupler 60.

In the illustrated example, the at least one optical amplifier 20, filtering means 12, mirror 58 and output coupler 60 are configured as an optical cavity 24.

In the example of Fig. 5, the cavity longitudinal modes/lasing modes 46 of the tunable laser 10 are defined by the optical length between the mirror 58 and the output coupler 60.

In the example of Fig. 5, the tunable laser 10 also comprises a phase section 62 configured to tune the selected lasing wavelength 42.

The tunable laser 10 of Fig. 5 also comprises two interferometers 34 configured to measure the phase difference 54 introduced by the ring resonators 26. In the example of FIG. 5, the interferometers 34 are configured to measure the phase difference 54 between the ring input and through port of the ring resonators 26.

In the example of Fig. 5, a tap 56 is configured to provide light to an input of the interferometers 34.

In the example of Fig. 5, the waveguide between the two rings 26 is bent to provide an equal distance between the two waveguides going from the tap 56 to the interferometers 34.

In the example of FIG. 5, waveguides are configured to allow the light to travel between and through components of the tunable laser 10.

Fig. 6 schematically illustrates an example of a tunable laser 10.

The example of Fig. 6 is similar to the example of Fig. 5.

However, in the example of Fig. 6, the interferometers 34 are configured to measure the phase difference 54 introduced by the ring resonators 26 between the ring inputs and drop ports.

Fig. 7 schematically illustrates an example of a tunable laser 10.

The example of Fig. 7 is similar to the examples of Fig. 5 and Fig. 6.

However, in the example of Fig. 7, the interferometers 34 are configured to measure the phase difference 54 introduced by the ring resonators 26 between the drop ports and through ports of the ring resonators 26.

In the example of FIG. 7, the measured phase difference 54 is equal to the difference between the phase differences 54 measured in the examples of FIGs 5 and 6.

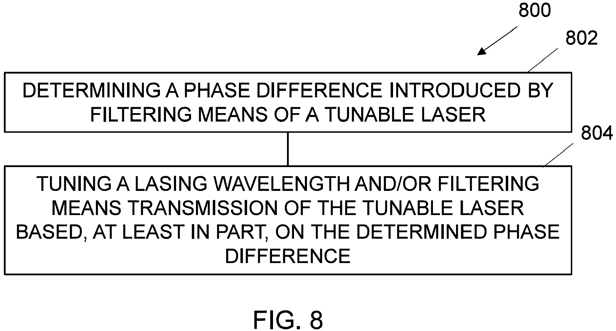

FIG. 8 illustrates an example of a method 800.

Method 800 can be considered a method of controlling one or more characteristics of light produced by a tunable laser 10, for example a tunable laser 10 as described herein.

At block 802, method 800 comprises determining a phase difference 54 introduced by filtering means 12 of a tunable laser 10.

Block 802 can be performed in any suitable way using any suitable method. See, for example, one or more of FIGs 1 to 7.

At block 804, method 800 comprises tuning a lasing wavelength 42 and/or filtering means transmission 44 of the tunable laser 10 based, at least in part, on the determined phase difference 54.

Block 804 can be performed in any suitable way using any suitable method. See, for example, one or more of FIGs 1 to 7.

Consequently, FIG. 8 illustrates a method comprising:
determining a phase difference 54 introduced by filtering means 12 of a tunable laser 10; and
tuning a lasing wavelength 42 and/or filtering means transmission 44 of the tunable laser 10 based, at least in part, on the determined phase difference 54.

According to some, but not necessarily all, examples of the disclosure there is provided a method comprising:
providing a tunable laser 10 comprising;
filtering means 12 configured to select a lasing mode 46 of the tunable laser 10;
means for determining 16 a phase difference 54 introduced by the filtering means 12; and
means for tuning 18 the lasing wavelength 42 and/or filtering means transmission 44 based, at least in part, on the determined phase difference 54.

In some, but not necessarily all, examples of the disclosure there is provided a method of providing a tunable laser 10 as described herein.

The various features of the tunable laser 10 can be provided in any suitable way using any suitable method or methods.

As used herein, providing should be considered to include, at least, making, manufacturing, producing, creating, constructing, and/or fabricating.

According to some, but not necessarily all, examples of the disclosure there is provided a method comprising using at least one tunable laser 10 as described herein.

As used in this application, the term 'circuitry' may refer to one or more or all of the following:
(a) hardware-only circuitry implementations (such as implementations in only analog and/or digital circuitry) and
(b) combinations of hardware circuits and software, such as (as applicable):
   (i) a combination of analog and/or digital hardware circuit(s) with software/firmware and
   (ii) any portions of hardware processor(s) with software (including digital signal processor(s)), software, and memory(ies) that work together to cause an apparatus, such as a mobile phone or server, to perform various functions and
(c) hardware circuit(s) and or processor(s), such as a microprocessor(s) or a portion of a microprocessor(s), that requires software (e.g. firmware) for operation, but the software may not be present when it is not needed for operation.

This definition of circuitry applies to all uses of this term in this application, including in any claims. As a further example, as used in this application, the term circuitry also covers an implementation of merely a hardware circuit or processor and its (or their) accompanying software and/or firmware. The term circuitry also covers, for example and if applicable to the particular claim element, a baseband integrated circuit for a mobile device or a similar integrated circuit in a server, a cellular network device, or other computing or network device.

Where a structural feature has been described, it may be replaced by means for performing one or more of the functions of the structural feature whether that function or those functions are explicitly or implicitly described.

The term 'comprise' is used in this document with an inclusive not an exclusive meaning. That is any reference to X comprising Y indicates that X may comprise only one Y or may comprise more than one Y. If it is intended to use 'comprise' with an exclusive meaning then it will be made clear in the context by referring to "comprising only one.." or by using "consisting".

In this description, reference has been made to various examples. The description of features or functions in relation to an example indicates that those features or functions are present in that example. The use of the term 'example' or 'for example' or 'can' or 'may' in the text denotes, whether explicitly stated or not, that such features or functions are present in at least the described example, whether described as an example or not, and that they can be, but are not necessarily, present in some of or all other examples. Thus 'example', 'for example', 'can' or 'may' refers to a particular instance in a class of examples. A property of the instance can be a property of only that instance or a property of the class or a property of a sub-class of the class that includes some but not all of the instances in the class. It is therefore implicitly disclosed that a feature described with reference to one example but not with reference to another example, can where possible be used in that other example as part of a working combination but does not necessarily have to be used in that other example.

Although examples have been described in the preceding paragraphs with reference to various examples, it should be appreciated that modifications to the examples given can be made without departing from the scope of the claims.

Features described in the preceding description may be used in combinations other than the combinations explicitly described above.

Although functions have been described with reference to certain features, those functions may be performable by other features whether described or not.

Although features have been described with reference to certain examples, those features may also be present in other examples whether described or not.

The term 'a' or 'the' is used in this document with an inclusive not an exclusive meaning. That is any reference to X comprising a/the Y indicates that X may comprise only one Y or may comprise more than one Y unless the context clearly indicates the contrary. If it is intended to use 'a' or 'the' with an exclusive meaning then it will be made clear in the context. In some circumstances the use of 'at least one' or 'one or more' may be used to emphasis an inclusive meaning but the absence of these terms should not be taken to infer any exclusive meaning.

The presence of a feature (or combination of features) in a claim is a reference to that feature or (combination of features) itself and also to features that achieve substantially the same technical effect (equivalent features). The equivalent features include, for example, features that are variants and achieve substantially the same result in substantially the same way. The equivalent features include, for example, features that perform substantially the same function, in substantially the same way to achieve substantially the same result.

In this description, reference has been made to various examples using adjectives or adjectival phrases to describe characteristics of the examples. Such a description of a characteristic in relation to an example indicates that the characteristic is present in some examples exactly as described and is present in other examples substantially as described.

Whilst endeavoring in the foregoing specification to draw attention to those features believed to be of importance it should be understood that the Applicant may seek protection via the claims in respect of any patentable feature or combination of features hereinbefore referred to and/or shown in the drawings whether or not emphasis has been placed thereon.

## Claims

1. A tunable laser comprising:
filtering means configured to select a lasing mode of the tunable laser;
means for determining a phase difference introduced by the filtering means; and
means for tuning the lasing wavelength and/or filtering means transmission based, at least in part, on the determined phase difference.

2. A tunable laser as claimed in claim 1, comprising at least one optical amplifier and light guiding means, wherein the at least one optical amplifier and light guiding means are configured as an optical cavity to produce laser light at a plurality of different modes having different wavelengths and wherein the light guiding means comprise the filtering means.

3. A tunable laser as claimed in claim 1 or 2, wherein the filtering means are configured to filter light to select a mode from the plurality of modes.

4. A tunable laser as claimed in claim 1, 2 or 3, wherein the filtering means comprise at least one ring resonator.

5. A tunable laser as claimed in claim 4, wherein the means for determining a phase difference are configured to measure a phase difference between a ring resonator input and through ports, a ring resonator input and drop ports, or a ring resonator drop and through ports.

6. A tunable laser as claimed in any preceding claim, wherein the means for determining a phase difference comprises at least one interferometer.

7. A tunable laser as claimed in claim 6, wherein the filtering means comprises at least one ring resonator and the means for determining a phase difference comprises a plurality of interferometers per ring resonator.

8. A tunable laser as claimed in any of claims 2 to 7, wherein the light guiding means are configured to control the phase of light entering the means for determining a phase difference.

9. A tunable laser as claimed in any preceding claim, wherein the tunable laser comprises an integrated tunable laser.

10. A tunable laser as claimed in any preceding claim, wherein the means for tuning the lasing wavelength and/or filtering means transmission comprises heating means and/or means for injecting carriers into one or more waveguides.

11. A tunable laser as claimed in any preceding claim comprising means for measuring the lasing wavelength.

12. A system comprising:
at least one tunable laser as claimed in at least one of claim 1 to 11;
means for receiving signal output from the means for determining a phase difference; and
means for controlling the means for tuning the lasing wavelength and/or filtering means transmission.

13. A method comprising:
providing a tunable laser comprising:
filtering means configured to select a lasing mode of the tunable laser;
means for determining a phase difference introduced by the filtering means; and
means for tuning the lasing wavelength and/or filtering means transmission based, at least in part, on the determined phase difference.

14. A method comprising using at least one tunable laser as claimed in at least one of claims 1 to 11.

15. A method comprising:
determining a phase difference introduced by filtering means of a tunable laser; and
tuning a lasing wavelength and/or filtering means transmission of the tunable laser based, at least in part, on the determined phase difference.
